(19) Europäisches Patentamt
European Patent Office
Office européen des brevets

(11) **EP 4 386 414 A1**

(12) **EUROPEAN PATENT APPLICATION**

(43) Date of publication:
**19.06.2024  Bulletin 2024/25**

(21) Application number: **22214113.7**

(22) Date of filing: **16.12.2022**

(51) International Patent Classification (IPC):
**G01R 33/563** (2006.01)    **G01R 33/56** (2006.01)
**G01R 33/54** (2006.01)     **G01R 33/44** (2006.01)
**G01R 33/48** (2006.01)     **G01R 33/38** (2006.01)

(52) Cooperative Patent Classification (CPC):
**G01R 33/56341; G01R 33/445; G01R 33/543;**
**G01R 33/5607;** G01R 33/3806; G01R 33/3808;
G01R 33/4814

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Koninklijke Philips N.V.**
**5656 AG Eindhoven (NL)**

(72) Inventor: **VAN DEN BRINK, Johan Samuel**
**Eindhoven (NL)**

(74) Representative: **Philips Intellectual Property &
Standards**
**High Tech Campus 52**
**5656 AG Eindhoven (NL)**

(54) **NUCLEAR MAGNETIC RESONANCE SPECTROSCOPY FOR THE DETECTION OF A PREDETERMINED TISSUE TYPE**

(57)     Disclosed herein is a medical system (100, 300) comprising: an NMR system (102) configured for acquiring NMR data (134, 718) descriptive of a subject (112) within a measurement zone (118) and a memory (126) storing machine executable instructions (130) and pulse sequence commands (132). The pulse sequence commands are configured to control the NMR system to acquire the NMR data according to a diffusion weighted magnetic resonance protocol and comprises a radio-frequency pulse group (706) configured to spectrally suppress a first constituent of the NMR signal. The execution of the machine executable instructions causes a computational system (120) to: acquire (200) the NMR data; detect (202) a predetermined tissue type in the measurement zone using a second constituent of the NMR signal recorded in the NMR data; and provide (204) a signal (138) if the predetermined tissue type is detected.

Fig. 1

## Description

FIELD OF THE INVENTION

The invention relates to Nuclear Magnetic Resonance Spectroscopy, in particular to clinical use of Nuclear Magnetic Resonance Spectroscopy.

BACKGROUND OF THE INVENTION

Nuclear Magnetic Resonance (NMR) Spectroscopy is a common analytical technique used in Chemistry. NMR Spectroscopy uses a large static magnetic field to align the nuclear spins of atoms within a measurement zone. Time varying Radio-Frequency (RF) signals may be used to manipulate the orientation the nuclear spins. The nuclear spins in turn emit NMR resonances that can be analyzed to determine the composition of the sample being measured.

Unites States patent application publication US 2019/0076080 discloses an apparatus for non-invasive evaluations and in-vivo diagnostics includes an open magnet, an RF antenna, and an NMR analytics logical circuit communicatively coupled to the RF antenna. The open magnet is shaped to generate a static magnetic field that extends unilaterally into an object or internal organ of a subject when the open magnet is positioned against or in proximity to the object or subject, the static and RF magnetic fields shaped to generate a sensitive volume within a target region. The RF antenna or antenna array is configured to transmit RF pulses into the target region of the object or internal organ and receive sets of NMR signals generated by hydrogen or other elements, and the NMR analytics logical circuit is configured to obtain and analyze sets of NMR signals.

SUMMARY OF THE INVENTION

The invention provides for a medical system, a computer program, and a method in the independent claims. Embodiments are given in the dependent claims.

In one aspect the invention provides for a medical system that comprises an NMR system. The NMR system is configured for acquiring NMR data that is descriptive of a subject within a measurement zone. The NMR system comprises a magnet configured for generating a magnetic field with a predetermined magnetic field strength and a static magnetic field gradient in the measurement zone. In embodiments the magnet may generate static magnetic field.

The medical system further comprises a memory that stores machine-executable instructions and pulse sequence commands. The pulse sequence commands are configured for controlling the NMR system to acquire the NMR data according to a diffusion-weighted magnetic resonance protocol. The pulse sequence commands comprise a radio-frequency pulse group that is configured to suppress a first constituent of the NMR signal. The first constituent of the NMR signal is descriptive of a concentration of at least one tissue type in the measurement zone.

The medical system further comprises a computational system. Execution of the machine-executable instructions causes the computational system to acquire the NMR data by controlling the NMR system with the pulse sequence commands. Execution of the machine-executable instructions further causes the computational system to detect a predetermined tissue type in the measurement zone using a second constituent of the NMR signal recorded in the NMR data. The radio-frequency pulse group suppresses the first constituent of the NMR signal so that in the acquired NMR data, NMR signals due to the at least one tissue type are minimized or eliminated.

Execution of the machine-executable instructions further causes the computational system to provide a signal if the predetermined tissue type is detected.

This embodiment may be beneficial because it may provide for an improved means of detecting a particular predetermined tissue type. This for example may be useful in medical situations to detect various types of abnormal or pathological tissues.

Embodiments may thus provide for an improved means of detecting a predetermined tissue type in a subject. Different types of tissues such as fat, connective tissue, muscle, and pathological tissues such as cancerous tissue have different diffusion coefficients. Cancer tissue in particular has a low diffusion coefficient. To differentiate these different types of tissue, a diffusion weighted magnetic resonance protocol is used to make measurements within a measurement zone of an NMR system (NMR spectrometer). Depending upon where the measurement zone is positioned in the body different types of tissue may need to be differentiated. To improve the detection of the predetermined tissue type, the pulse sequence commands used to acquire the NMR data comprise a radio-frequency pulse group configured to suppress a first constituent of the NMR signal based on its distinct relaxation time or spectral characteristics.

In specific embodiments, the radio-frequency pulse group could be used for such things as eliminating or reducing the signal due to fat or adipose tissue. The signal-suppression radio-frequency pulse group could be used in other embodiments to suppress the contribution to the NMR signal by tissues with a T2 time above a predetermined threshold.

In another embodiment the radio-frequency pulse group is configured to suppress the first constituent based on its distinct relaxation time.

In another embodiment the radio-frequency pulse group is configured to suppress the first constituent based on its NMR spectral characteristics.

In another embodiment the radio-frequency pulse group is configured to suppress signals based on their T1 characteristics (longitudinal relaxation time).

In another embodiment the radio-frequency pulse group is configured to suppress signals based on their T2 characteristics (transverse relaxation time).

In another embodiment the radio-frequency pulse group is configured to suppress signals using Magnetization Transfer, either on-resonance or off-resonance.

In another embodiment the radio-frequency group comprises one or more radio frequency pulses.

In another embodiment, the magnet consists of at least one permanent magnet.

In another embodiment, the magnetic field generated by the magnet is non-uniform in the measurement zone. The non-uniformity of the magnetic field is the static gradient.

In another embodiment the predetermined tissue type is an abnormal tissue. Types of abnormal tissue include those with elevated pressure or otherwise restricted or altered diffusivity for example due to cell swelling or increased cellular density (rapid proliferation), as well as those showing any deviation in T2 or T1 for example due to edema, fibrosis or cell membrane disintegration.

In another embodiment the predetermined tissue type is cancer tissue. The detection of cancer tissue may be particularly beneficial because the diffusion of fluids within cancer tissue is greatly reduced. The use of the diffusion-weighted magnetic resonance protocol therefore enables the detection of cancer tissue.

In another embodiment the predetermined tissue type is fibrotic tissue.

In another embodiment the predetermined tissue type is an edema.

In another embodiment the predetermined tissue type is tissue with increased cellular density.

In another embodiment the predetermined tissue type is swollen brain tissue.

In another embodiment the first constituent is the NMR signal due to at least one tissue type.

In another embodiment, the predetermined tissue type is detected by assuming diffusion coefficients for the predetermined tissue type and at least one additional tissue type.

In another embodiment the predetermined tissue type is detected by assuming predetermined T2 relaxation times for the predetermined tissue type and at least one additional tissue type. The NMR signal may be modeled by assuming the presence of various types of tissues or biological substances. If these are known in advance then the T2 relaxation times for these tissues or biological substances can be assumed. This may provide for an increased accuracy in determination of the tissue type.

In another embodiment the predetermined tissue type is detected using at least one fitting parameter of a multi-exponential fit to the NMR data. The NMR data may contain NMR signals from a variety of tissue types or biological substances. The fitting of a multi-fit exponential to this data may allow the determination or detection of the relative amounts and/or presence of a particular tissue type. The fitting parameters which specify the signal due to the predetermined tissue type may have predetermined ranges which are set and if these fitting parameters are outside of this predetermined range then this may be used to indicate the presence of the predetermined tissue type.

In another embodiment the signal-suppression radio-frequency pulse group is a fat suppression radio-frequency pulse group. The at least one tissue type comprises fat tissue.

A short TI inversion-recovery (STIR) pulse sequence may be used to suppress fat. In this scheme a 180° inversion pulse is first applied. Later a 90° pulse is applied so that the NMR signal is excited at the time corresponding to the null point of a first constituent of the NMR signal, typically determined by the T1 of adipose tissue. This then eliminates adipose tissue from the NMR signal.

In another embodiment the preparatory radio-frequency pulse group applies a T2 filter to the NMR signal. The T2 preparatory pulse group is a preparatory radio-frequency pulse group at the beginning of the pulse sequence commands and can be used to select a window of T2 values, and thereby suppresses signal constituents outside this T2-value window.

In another embodiment, the preparatory pulse group may be a series of radiofrequency pulses that perform magnetization-transfer preparation through on-resonance or off-resonance saturation of a first constituent of the NMR signal. Such magnetization-transfer preparation can modulate the detected NMR data as function of macromolecular concentration in the at least one tissue type.

In a further embodiment, the NMR data is detected alternatively and possibly repetitively with the magnetization-transfer preparation being on and off. Subsequently, difference data is obtained between the acquired data where the magnetization-transfer is on and off, which difference (on - off) data or ratio (on-off)/off data enhances the sensitivity for variations in macromolecular content across tissue types. This enhanced sensitivity can be used to more accurately generate the signal that indicates presence of abnormal tissue

In another embodiment, combination of multiple preparatory pulse groups is applied to further enhance the selectivity of the detection of a constituent of the NMR signals. One advantageous example is when the combination consists of first employing a a short tau inversion recovery (STIR) pre-pulse with a short inversion time (TI) which is then followed by a multi-pulse adiabatic-based T2-prep module (where typically four pulses are needed to implement the T2 filter). The choice of echo times in the T2 preparatory pulse train may be used to exclude materials above a predetermined T2 value threshold from the NMR signal.

In another embodiment the pulse sequence comprises radio-frequency excitation pulses. In one example, these excitation pulses can be broadband. In another example these excitation pulses are frequency-selective to additionally suppress a first constituent of the NMR signal. One example of such frequency-selective RF pulses is the use of binomial excitation pulses, which in its simplest form excites the NMR signal by a 45° pulse, allows for a precession period during which the water and fat components evolve to opposite phase, and apply another 45° pulse which further excites the water component into the xy-plane (detectable magnetization), and restores the fat component to the z-axis (not-detectable magnetization)

In another embodiment, execution of the machine-executable instructions further causes the computational system to repeatedly shift the measurement zone by adjusting the frequency of the radio-frequency excitation pulses. Execution of the machine-executable instructions further causes the computational system to repeatedly reacquire the NMR data by controlling the NMR system with the pulse sequence commands that have been adjusted. Execution of the machine-executable instructions further causes the computational system to detect the predetermined tissue type in the shifted measurement zone using the NMR data. Execution of the machine-executable instructions further causes the computational system to provide a signal if the predetermined tissue type is detected in the repeatedly shifted measurement zone. This embodiment may be beneficial because it may provide for a means of checking different regions within the subject for the predetermined tissue type.

In another embodiment the magnet is an open magnet.

In another embodiment the measurement zone is adjacent to the magnet. This is equivalent to saying that the measurement zone is not enclosed by the magnet.

In another embodiment the magnet is a unilateral magnet. This embodiment may be beneficial because it may provide for a means of providing the magnetic field with the predetermined magnetic field strength and the static magnetic field gradient.

In another embodiment the magnet is within a probe. The NMR system further comprises a radio-frequency coil configured for receiving the NMR data as radio-frequency signals. The radio-frequency coil is within the probe. This embodiment may be beneficial because it may provide for a means of detecting the chosen tissue type within the subject.

The probe could for example be an endovaginal probe or an endoscopic probe.

In another embodiment the magnet has a proximal and distal surface. The distal surface has negative curvature for receiving a body part of the subject. For example, the distal surface may be adjacent to the measurement zone.

In another embodiment the body part is a breast. This may be beneficial because it may provide for a means of detecting a chosen tissue type such as cancer tissue without the use of a biopsy.

In another embodiment, the body part is a head. This may be beneficial because it may enable detecting the chosen tissue type in the brain of the subject or in other tissues in the subject's head.

In another embodiment, the body part is a thorax. This may be beneficial because it may enable detecting the chosen tissue type in such body regions as the lungs, liver, or kidney.

In another embodiment the body part is an upper leg portion such that the measurement zone is positioned in or at the location of the subject's prostate. This may provide for an improved means of detecting cancerous tissue within the prostate of the subject.

In another embodiment the magnet is within an ultrasound probe. The ultrasound probe is configured for acquiring ultrasound data from an ultrasound imaging zone. The medical system further comprises an ultrasound imaging system. The ultrasound imaging system comprises the ultrasound probe. Execution of the machine-executable instructions further causes the computational system to control the ultrasound imaging system to acquire the ultrasound data. Execution of the machine-executable instructions further causes the computational system to reconstruct an ultrasound image from the ultrasound data. Execution of the machine-executable instructions further causes the computational system to identify a target zone in the ultrasound image. Execution of the machine-executable instructions further causes the computational system to modify the pulse sequence commands to place the measurement zone within the target. This embodiment may be beneficial because it may provide for an effective means of adjusting the measurement zone to examine a desired tissue or tumor.

In another embodiment, the measurement zone is within the ultrasound imaging zone.

In another embodiment the pulse sequence is a Carr-Purcell-Meiboom-Gill pulse sequence. This embodiment may be beneficial because it enables the acquisition of diffusion-weighted magnetic resonance imaging data using a static magnetic field gradient.

In another aspect the invention provides for a computer program comprising machine-executable instructions for execution by a computational system controlling a medical system. The medical system comprises an NMR system. The NMR system is configured for acquiring NMR data descriptive of a subject within a measurement zone. The NMR system comprises a magnet configured for generating a magnetic field within a predetermined magnetic field strength and a static magnetic field gradient in the measurement zone. Execution of the machine-executable instructions causes the computational system to acquire the NMR data by controlling the NMR system with the pulse sequence commands.

The pulse sequence commands are configured to control the NMR system to acquire the NMR data according to a diffusion-weighted magnetic resonance protocol. The pulse sequence commands comprise a radio-frequency pulse group that is configured to suppress a first constituent of the NMR signal. The first constituent of the NMR signal is descriptive of a concentration of at least one tissue type. Execution of the machine-executable instructions further causes the computational system to detect a predetermined tissue type in the measurement zone using a second constituent of the NMR signal recorded in the NMR data. Execution of the machine-executable instructions further causes the computational system to provide a signal if the predetermined tissue type is detected.

In another aspect the invention provides for a method of operating an NMR system configured for acquiring NMR data that is descriptive of a subject within a measurement zone. The NMR system comprises a magnet configured for generating a magnetic field with a predetermined magnetic field strength and a static magnetic field gradient in the measurement zone. The measurement comprises acquiring the NMR data by controlling the NMR system with the pulse sequence commands. The pulse sequence commands are configured to control the NMR system to acquire the NMR data.

The pulse sequence commands comprise a radio-frequency pulse group configured to suppress a first constituent of the NMR signal. The first constituent of the NMR signal is descriptive of a concentration of at least one tissue type. The method further comprises detecting a predetermined tissue type in a measurement zone using a second constituent of the NMR signal recorded in the NMR data. The method further comprises providing a signal if the predetermined tissue type is detected.

The signal may take different forms in different examples. In one example the signal could trigger a response from an auditory, visual or user interface to warn the operation of the medical system. In other examples, the signal may be used to trigger other components of the medical system. In one example, the signal could automatically trigger the ordering of a biopsy. For example, it could be used to automatically schedule a biopsy for the subject and/or cause materials for the biopsy to be ordered and delivered to an examination location.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined.

These computer program instructions may be provided to a computational system of a general purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus.

Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

BRIEF DESCRIPTION OF THE DRAWINGS

In the following preferred embodiments of the invention will be described, by way of example only, and with reference to the drawings in which:

> Fig. 1 illustrates an example of a medical system;
> Fig. 2 shows a flow chart which illustrates a method of using the medical system of Fig. 1;
> Fig. 3 illustrates a further example of a medical system;
> Fig. 4 shows a flow chart which illustrates a method of using the medical system of Fig. 3;
> Fig. 5 illustrates an example of a magnet;
> Fig. 6 illustrates a further example of a magnet; and
> Fig. 7 illustrates an example of a pulse sequence.

DETAILED DESCRIPTION OF EMBODIMENTS

Like numbered elements in these figures are either equivalent elements or perform the same function. Elements which have been discussed previously will not necessarily be discussed in later figures if the function is equivalent.

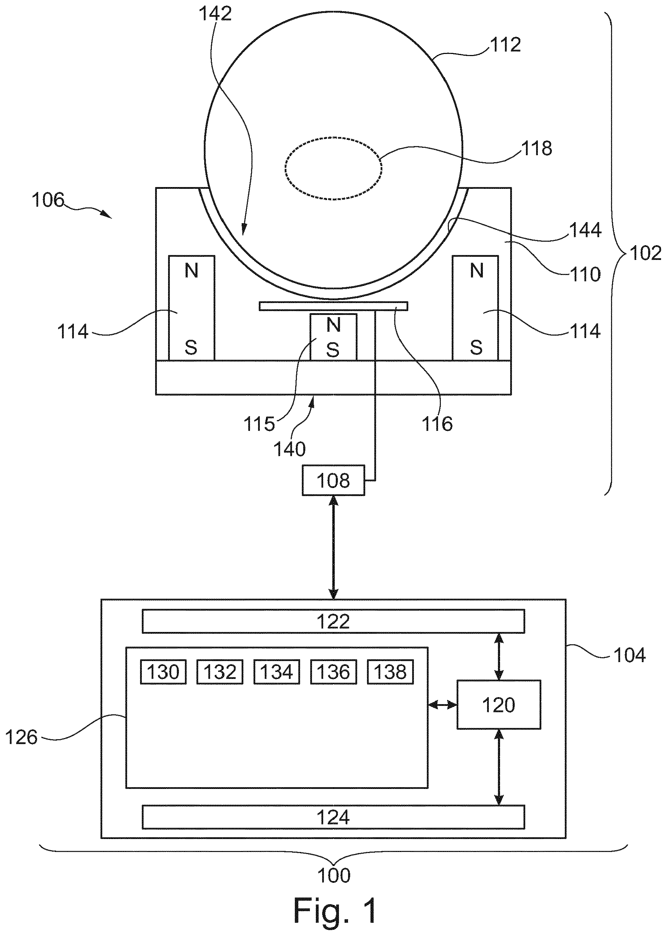

Fig. 1 illustrates an example of a medical system 100. The medical system 100 is shown as comprising an NMR system 102 and a computer 104. The NMR system 102 is shown as comprising a magnet assembly 106 and a radio-frequency system 108. The radio-frequency system 108 may comprise a transmitter and receiver or a transceiver.

The magnet assembly 106 comprises a housing which is configured for receiving a portion of a subject 112. Within the housing 110 there is a number of magnets 114, 115. In this particular example there is a ring of magnets 114 that is arranged around an axis of symmetry.

There is also a central magnet 115 which the axis of symmetry also goes through. In this example permanent or static magnets 114, 115 are used.

This is however only one example. There is a large variety of arrangements of magnets which may be used as well as a variety of magnet types. For example, in addition to permanent magnets, resistive magnets may be used as well as super-conducting magnets. The radio-frequency system 108 is shown as being connected to a radio-frequency antenna 116. The radio-frequency antenna 116 is configured for manipulating spins within a measurement zone 118 and also for receiving radio-frequency signals from these spins. The measurement zone 118 is a function of the magnetic field generated by the magnets 114, 115 and also excitation frequency generated by the radio-frequency antenna 116. As such, by changing the excitation frequency in the pulse sequence the position of the measurement zone 118 can be moved further away or closer to the housing 110.

The computer 104 is shown as comprising a computational system 120. The computational system 120 is intended to represent different types of computational or computing systems such as processor cores or programmable field gate arrays. The computational system 120 is shown as being connected to a hardware interface 122 which is shown as being configured for controlling the radio-frequency system 108. The hardware interface 122 enables the computational system 120 to not only control the NMR system 102 but also to receive data from it. The computational system 120 is shown as being further connected to an optional user interface 124. The computational system 120 is shown as being further connected to a memory 126. The memory 126 is intended to represent different types of memory which may be accessible to the computational system 120.

The memory 126 is shown as containing machine-executable instructions 130. The machine-executable instructions contain instructions which enable the computational system 120 to control the NMR system as well as to perform data analysis and numerical tasks. The memory 126 is further shown as containing pulse sequence commands 132. The pulse sequence commands 132 enable the computational system 120 to control the NMR system 102 to acquire NMR data according to a diffusion-weighted magnetic resonance protocol. The memory 126 is further shown as containing NMR data 134 that has been acquired by the NMR system 102 when controlled with the pulse sequence commands 132.

The memory 126 is further shown as containing a detection of a predetermined tissue type 136 in the NMR data 134. This could for example be performed by a multi-exponential fit to the acquired NMR data 134. The pulse sequence commands 132 are configured to acquire the NMR data 134 according to a diffusion-weighted magnetic resonance protocol. This means that the measurement will be acquired for a variety of the so-called different b-values. Putting a multi-exponential to these data with different b-values may be used for determining if the predetermined tissue type is present. The memory 126 is further shown as containing a signal 138 that is generated in response to the detection of the predetermined tissue type 136. This for example may cause the user interface 124 to do such things as provide an alert or the computer system 104 may communicate with other components or cause a change in the operation of the medical system 100.

The magnet assembly 106 is shown as having a proximal surface 140 and a distal surface 142. The distal surface 142 has a negative curvature 144 that is configured for receiving the position of the subject 112.

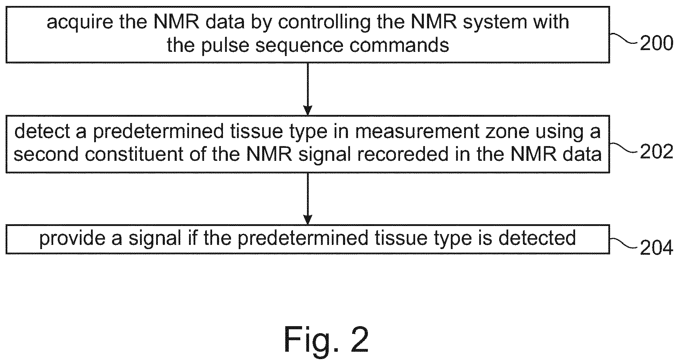

Fig. 2 shows a flowchart which illustrates a method of operating the medical system 100 of Fig. 1. First in step 200 the NMR data 134 is acquired by controlling the NMR system 102 with the pulse sequence commands 132. Next, in step 202, the predetermined tissue type is detected in the measurement zone 118 using a second constituent of the NMR signal recorded in the NMR data 134. Finally, in step 204, the signal 138 is provided if the predetermined tissue type is detected.

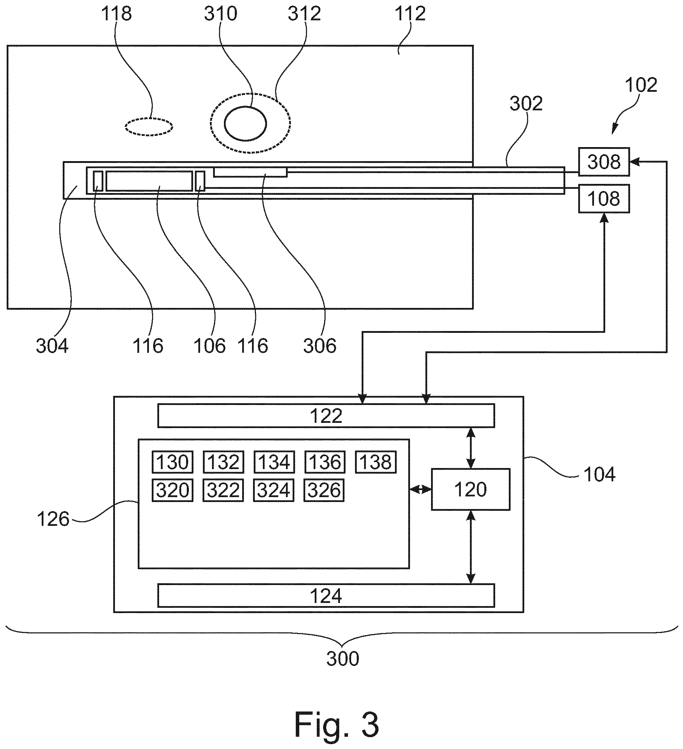

Fig. 3 illustrates a further example of a medical system 300. This example is similar to the medical system 100 depicted in Fig. 1 except in this case the NMR system 102 is incorporated into a probe 302. The probe 302 is shown as being inserted into an orifice 304 of the subject 112. The probe 302 has an ultrasound transducer 306 connected to an ultrasound system 308. A tumor 310 is shown as being within an ultrasound imaging zone 312. The operator of the medical system 300 is therefore able to image the tumor 310 by positioning the ultrasound transducer 306 in the proper position. This may be very useful when trying to examine a specific portion of a prostate or for imaging a lump. At the tip of the probe 302 is shown the magnet assembly 106 which is between two radio-frequency antennas 116.

The NMR portion 116, 106 provides for a measurement zone 118 for the NMR system 102. In this example the ultrasound imaging zone 312 does not overlap with the measurement zone 118. However, there would be a known relationship between the position of the ultrasound imaging zone 312 and the measurement zone 118. For example, the operator or physician could locate the tumor 310 with the ultrasound transducer 306 and then withdraw the probe 302 a known amount to properly position the measurement zone 118. The distance 118 of the measurement zone from the probe 302 may also be controlled by modifying the pulse sequence commands. By modifying the pulse sequence commands and/or withdrawing the probe 302 the measurement zone 118 can very precisely be placed on the tumor 310.

The memory 126 is further shown as containing ultrasound data 320 that was acquired using the ultrasound system 308. The memory 126 is further shown as containing ultrasound image 322 that was reconstructed from the ultrasound data 320. The memory 126 is further shown as containing a target located in the ultrasound image 324. In this case it would be identification of the tumor 310. This could for example be done manually or it could be performed by a segmentation algorithm. The memory 126 is further shown as containing modified pulse sequence commands 326. These may for example be used to modify the distance of the measurement zone 118 from the probe 302 by changing an excitation frequency in the pulse sequence commands.

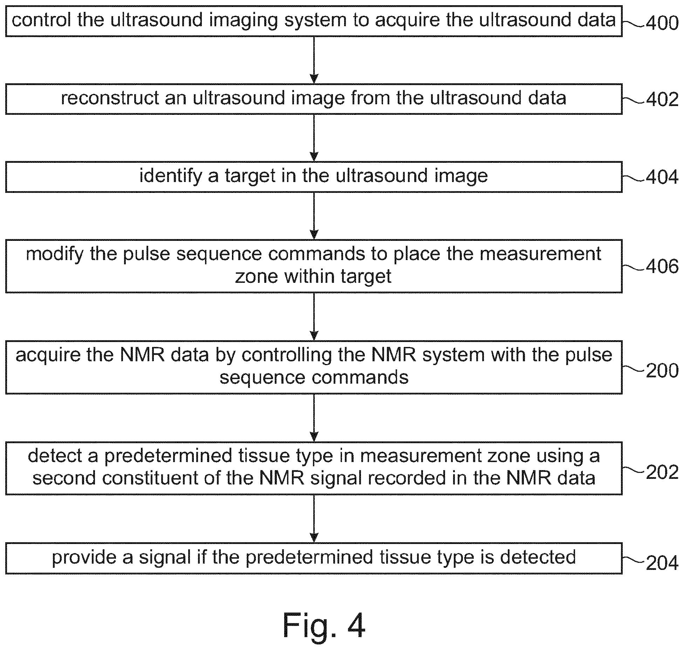

Fig. 4 shows a flowchart which illustrates a method of operating the medical system 300 of Fig. 3. First, in step 400, the ultrasound imaging system 308 is controlled to acquire the ultrasound data 320. Next, in step 402, the ultrasound image 322 is reconstructed from the ultrasound data 320. Next, in step 404, the target 324 is located in the ultrasound image 322. Next, in step 406, the pulse sequence commands 132 are modified to place the measurement zone within the target 324. After step 406 steps 200, 202, and 204 are performed as was illustrated in Fig. 2.

When performing the method illustrated in Fig. 4 the steps of imaging and reconstructing the ultrasound image 402 may be performed multiple times until the operator is able to locate the tumor 310. The arrangement illustrated in Fig. 3 may be advantageous because with an NMR system spatial images are not normally acquired if the measurement is performed on the measurement zone 118 as a whole. The use of the ultrasound system 308 may therefore greatly accelerate the search for the predetermined tissue type.

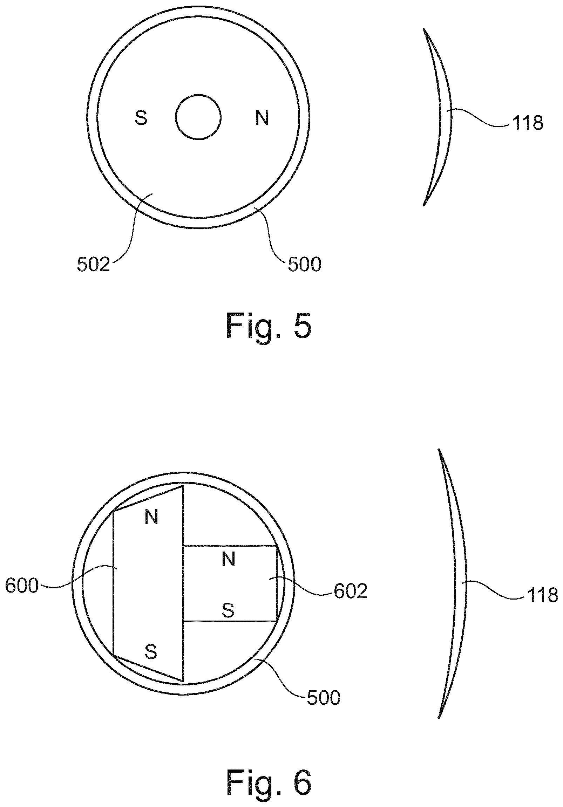

Fig. 5 illustrates one way of constructing a magnet 502 for use in the probe 302. Inside of the probe wall 500 there is a cylindrical magnet 502. The approximate location of the measurement zone 118 is shown. The magnet 502, and also in the example shown below in Fig. 6, may be constructed using a neodymium (NdFeB) magnet. It is possible to obtain small magnets of the size which could be inserted into a probe with an outer diameter of typically less than 2-3 cm, and providing a magnetic field strength of approximately 0.2T to 0.3T. This would be sufficient to construct an NMR system.

The magnet if Fig. 5 may also be replaced with a cylindrical magnet with a hole where both poles encircle the hole. In this case one pole is nearer to the hole than the other pole.

Fig. 6 illustrates a further example. There are two magnets 600, 602 within the enclosure 500 of the probe. Again, the approximate measurement zone 118 adjacent to the magnets 600, 602 is shown.

Two examples of the magnet for use in the probe were illustrated in Figs. 5 and 6. However other possibilities exist. Other examples, which provide for a magnet that is axially magnetized, diametrically magnetized, or radially magnetized may also be used.

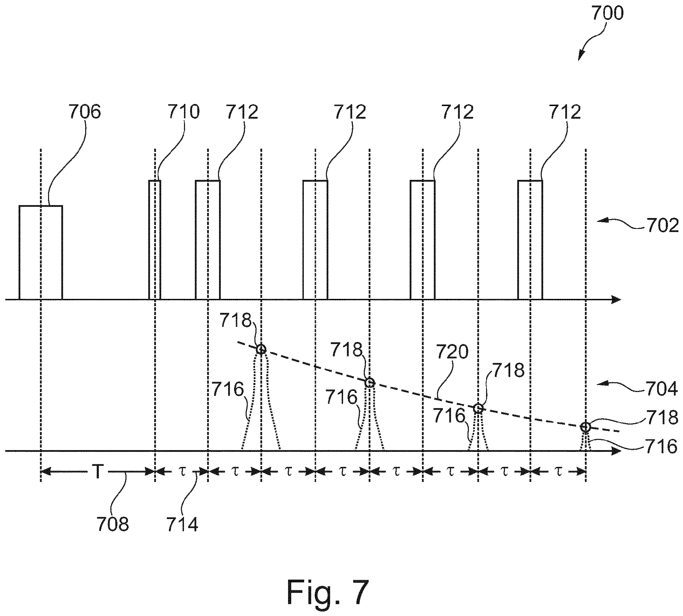

Fig. 7 illustrates a modified Carr-Purcell-Meiboom-Gill (CPMG) pulse sequence 700. The pulse sequence does not contain any gradient pulses. Pulse sequence 700 is a diffusion-weighted magnetic resonance protocol. It comprises a series of radio-frequency pulses 702 and a number of radio-frequency measurements 704 which are shown in a timing chart. The pulse sequence begins with a radio-frequency pulse group 706 to suppress a first constituent of the NMR signal. RF pulse 706 occurs at a time T 708 before the rest of the pulse sequence. After time T 708 a 90° pulse 710 is performed. After a time τ714 a 180° pulse 712 is performed. The 180° pulses 712 are performed thereafter at intervals of 2τ. Below, in the measurement section, it can be seen that a time τ 714 after the first 180° pulse 712 there is an NMR resonance 716. This NMR resonance 716 is sampled at time τ 714 after the first 180° pulse 712. The NMR resonance 716 reoccurs at intervals of 2τ and the NMR data 134 is sampled at intervals of 2τ after the first sample 718. The dashed line 720 shows the decay of the sampled NMR signal 720. The NMR signal 720 may be dependent upon multiple components within the subject 112.

If the radio-frequency pulse group 706 is for suppressing fat, the radio-frequency pulse group 706 would be a 180° inversion pulse. The time T 708 is the time for the null point of adipose tissue, typically in the order of 250-300 ms. The application of the 90° pulse 710 then effectively eliminates any detectable NMR signal from adipose tissue during the CPMG sequence's train of echoes.

As was mentioned above, the T2 preparatory excitation pulse group may be a series of pulses that perform magnetization preparation. The time interval of the pulses in this T2 preparatory pulse group can be chosen to apply a filter of excited or suppressed T2 values. It can also be combined with the RF pulse 706 described above for combined T1 and T2 selectivity.

The sample points 718 define the NMR signal 720 as a function of the so called "b" value. The value of the NMR signal depends upon the signal contributed from different tissues or substances within the measurement zone. A multi-exponential may be fit to the curve 720 to detect the predetermined tissue type. The curve represents a T2 decay of the NMR signal, which is further attenuated by diffusion effects. The combined decay can be evaluated by the multi-exponential fit.. For example, if one assumes that there are two tissue types in the measurement zone, the signal represented by the curve 720 can be modeled with the following equation:

$$S(t) = Ae^{-at} + Be^{-bt},$$

With $S(t)$ being the value of the curve 720 at time $t$. $A$ and $a$ are fitting parameters for a first tissue type and $B$ and $b$ are fitting parameters for a second tissue type. $a$ and $b$ are dependent upon the diffusion coefficients for the two tissue types. In many cases the values for $a$ and $b$ are known ahead of time and do not need to be fit. The equation for $S(t)$ can be fit to the sample points 718. If the predetermined tissue type is modeled by the first term in $S(t)$ then the value of $A$ after the fitting can be used to detect if the predetermined tissue type is in the measurement zone. For example, a predetermined threshold could be used to determine if the predetermined tissue type is present or not.

The above equation for $S(t)$ above, may of course have many more than two terms to account for the contribution to the NMR signal by many different tissue types. A disadvantage of this is that as the number of terms increases there may be more error in the detection of the predetermined tissue type. The use of the radio-frequency pulse group 706 at the beginning of the pulse sequence is that it effectively removes terms from $S(t)$ which simplifies the problem and improves the accuracy in the detection of the predetermined tissue type.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

REFERENCE SIGNS LIST

| 100 | medical system |
| 102 | NMR System |
| 104 | computer |
| 106 | magnet assembly |
| 108 | radio-frequency system |
| 110 | housing |
| 112 | portion of subject |
| 114 | ring of magnets |
| 115 | central magnet |
| 116 | radio-frequency antenna |
| 118 | measurement zone |
| 120 | computational system |
| 122 | hardware interface |
| 124 | user interface |
| 126 | memory |
| 130 | machine executable instructions |

132    pulse sequence commands
134    NMR data
136    detection of predetermined tissue type
138    signal
140    proximal surface
142    distal surface
144    negative curvature
200    acquire the NMR data by controlling the NMR system with the pulse sequence commands
202    detect a predetermined tissue type in measurement zone using a second constituent of the NMR signal recorded in the NMR data
204    provide a signal if the predetermined tissue types is detected
300    medical system
302    probe
304    orifice
306    ultrasound transducer
308    ultrasound system
310    tumor (target zone)
312    ultrasound imaging zone
320    ultrasound data
322    ultrasound image
324    target located in ultrasound image
326    modified pulse sequence commands
400    control the ultrasound imaging system to acquire the ultrasound data
402    reconstruct an ultrasound image from the ultrasound data
404    identify a target in the ultrasound image
406    modify the pulse sequence commands to place the measurement zone within the target
500    probe wall
502    cylindrical magnet
600    magnet
602    magnet
700    modified Carr-Purcell-Meiboom-Gill pulse sequence
702    RF pulses
704    measurments
706    radio-frequency pulse group
708    time T
710    90° pulse
712    180° pulse
714    time τ
716    NMR resonance
718    measurment point of NMR data
720    T2 relaxation of NMR signal

**Claims**

1.  A medical system (100, 300) comprising:

    - an NMR system (102) configured for acquiring NMR data (134, 718) descriptive of a subject (112) within a measurement zone (118), wherein the NMR system comprises a magnet (106, 114, 115, 502, 600, 602) configured for generating a magnetic field with a predetermined magnetic field strength and a static magnetic field gradient in the measurement zone;
    - a memory (126) storing machine executable instructions (130) and pulse sequence commands (132, 700), wherein the pulse sequence commands are configured to control the NMR system to acquire the NMR data according to a diffusion weighted magnetic resonance protocol, wherein the pulse sequence commands comprise a signal-component suppression radio-frequency pulse group (706) configured to suppress a first constituent of the NMR signal, wherein the first constituent of the NMR signal is descriptive of a concentration of at least one tissue type;
    - a computational system (120), wherein execution of the machine executable instructions causes the computational system to:

        - acquire (200) the NMR data by controlling the NMR system with the pulse sequence commands;
        - detect (202) a predetermined tissue type in the measurement zone using a second constituent of the NMR signal recorded in the NMR data; and
        - provide (204) a signal (138) if the predetermined tissue type is detected.

2.  The medical system of claim 1, wherein the predetermined tissue type is an abnormal tissue, and wherein the abnormal tissue is preferably any one of the following: cancer tissue, fibrotic tissue, an edema, tissue with increased cellular density, and swollen brain tissue.

3.  The medical system of any one of the preceding claims, wherein the predetermined tissue type is detected by assuming diffusion coefficients for the predetermined tissue type and at least one additional tissue type.

4.  The medical system of any one of the preceding claims, wherein the predetermined tissue type is detected by assuming predetermined T2 relaxation times for the predetermined tissue type and at least one additional tissue type.

5.  The medical system of any one of the preceding claims, wherein the predetermined tissue type is detected using at least one fitting parameter of a multi-exponential fit to a relaxation curve (720) described by the NMR data.

6.  The medical system of any one of the preceding claims, wherein the radio-frequency pulse group is a fat suppression radio-frequency pulse, and wherein the at least one tissue type comprises fat tissue.

7. The medical system of any one of claim 1 through 4, wherein the radio-frequency pulse group is a T2-preparatory excitation pulse.

8. The medical system of any one of the preceding claims, wherein the pulse sequence comprises radio-frequency excitation pulses, wherein execution of the machine executable instructions further causes the computational system to repeatedly:

   - shift the measurement zone by adjusting the frequency of the radio-frequency excitation pulses;
   - reacquire the NMR data by controlling the NMR system with the pulse sequence commands; and
   - detect the predetermined tissue type in the shifted measurement zone using the NMR data;

   wherein execution of the machine executable instructions further causes the computational system to provide a signal if the predetermined tissue type is detected in the repeatedly shifted measurement zone.

9. The medical system of any one of the preceding claims, wherein magnet is an open magnet.

10. The medical system of any one of the preceding claims, wherein the magnet has proximal (140) and distal surfaces (142), wherein the distal surface has negative curvature (144) for receiving a body part of the subject, and wherein any one of the following:

   - the body part is a breast;
   - the body part is a head;
   - the body part is a throrax;
   The body part is an abdomen; and
   - the body part is an upper leg portion such that the measurement zone is positioned in the prostate.

11. The medical system of any one of claims 1 through 8, wherein the magnet is within a probe (302), wherein the NMR system further comprises a radio-frequency coil (116) configured for receiving the NMR data as radio-frequency signals, and wherein the radio-frequency coil is within the probe.

12. The medical system of any one of claims 1 through 9, wherein the probe is an ultrasound probe, wherein the ultrasound probe is configured for acquiring ultrasound data (320) from an ultrasound imaging zone (312), wherein the medical system further comprises an ultrasound imaging system (308), wherein the ultrasound imaging system comprises the ultrasound probe, wherein execution of the machine executable instructions further causes the computational system to:

   - control (400) the ultrasound imaging system to acquire the ultrasound data;
   - reconstruct (402) an ultrasound image (322) from the ultrasound data;
   - identify (404) a target zone (310) in the ultrasound image; and
   - modify (406) the pulse sequence commands to place the measurement zone within the target.

13. The medical system of any one of the preceding claims, wherein the a pule sequence is a Carr-Purcell-Meiboom-Gill pulse sequence (700).

14. A computer program comprising machine executable instructions for execution by a computational system (120) controlling a medical system (100, 300), wherein the medical system comprises an NMR system (102) configured for acquiring NMR data (134, 718) descriptive of a subject (112) within a measurement zone (118), wherein the NMR system comprises a magnet (106, 114, 115, 502, 600, 602) configured for generating a magnetic field with a predetermined magnetic field strength and a static magnetic field gradient in the measurement zone, wherein execution of the machine executable instructions causes the computational system to:

   - acquire (200) the NMR data by controlling the NMR system with pulse sequence commands (132, 700), wherein the pulse sequence commands are configured to control the NMR system to acquire the NMR data according to a diffusion weighted magnetic resonance protocol, wherein the pulse sequence commands comprise a radio-frequency pulse group (706) configured to spectrally suppress a first constituent of the NMR signal, wherein the first constituent of the NMR signal is descriptive of a concentration of at least one tissue type;
   - detect (202) a predetermined tissue type in the measurement zone using a second constituent of the NMR signal recorded in the NMR data
   - provide (204) a signal (138) if the predetermined tissue types is detected.

15. A method of operating an NMR system (100, 300) configured for acquiring NMR data (134, 718) descriptive of a subject (112) within a measurement zone (118), wherein the NMR system comprises a magnet (106, 114, 115, 502, 600, 602) configured for generating a magnetic field with a predetermined magnetic field strength and a static magnetic field gradient in the measurement zone, wherein the method comprises:

- acquiring (200) the NMR data by controlling the NMR system with pulse sequence commands (132, 700), wherein the pulse sequence commands are configured to control the NMR system to acquire the NMR data, wherein the pulse sequence commands comprise a radio-frequency pulse group (706) configured to spectrally suppress a first constituent of the NMR signal, wherein the first constituent of the NMR signal is descriptive of a concentration of at least one tissue type;
- detecting (202) a predetermined tissue type in measurement zone using a second constituent of the NMR signal recorded in the NMR data
- providing (204) a signal (138) if the predetermined tissue types is detected.

Fig. 1

acquire the NMR data by controlling the NMR system with
the pulse sequence commands ⎤~200

detect a predetermined tissue type in measurement zone using a
second constituent of the NMR signal recoreded in the NMR data ⎤~202

provide a signal if the predetermined tissue type is detected ⎤~204

# Fig. 2

Fig. 3

control the ultrasound imaging system to acquire the ultrasound data — 400

↓

reconstruct an ultrasound image from the ultrasound data — 402

↓

identify a target in the ultrasound image — 404

↓

modify the pulse sequence commands to place the measurement zone within target — 406

↓

acquire the NMR data by controlling the NMR system with the pulse sequence commands — 200

↓

detect a predetermined tissue type in measurement zone using a second constituent of the NMR signal recorded in the NMR data — 202

↓

provide a signal if the predetermined tissue type is detected — 204

## Fig. 4

Fig. 5

Fig. 6

Fig. 7

Europäisches
Patentamt

European
Patent Office

Office européen
des brevets

# EUROPEAN SEARCH REPORT

Application Number

EP 22 21 4113

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ROBIN A DE GRAAF ET AL: "Single-shot diffusion trace 1H NMR spectroscopy", MAGNETIC RESONANCE IN MEDICINE, vol. 45, no. 5, 16 April 2001 (2001-04-16), pages 741-748, XP055229774, US ISSN: 0740-3194, DOI: 10.1002/mrm.1101 | 1-3,6, 8-11,14, 15 | INV.<br>G01R33/563<br>G01R33/56<br>G01R33/54<br>G01R33/44<br><br>ADD. |
| Y | * page 742 - page 743; figures 1, 2, 3 * | 12 | G01R33/48 |
| A | * page 747 * | 4,5,7,13 | G01R33/38 |
| Y | GÜNTHER MATTHIAS ET AL: "Ultrasound-guided MRI: Preliminary results using a motion phantom", MAGNETIC RESONANCE IN MEDICINE, vol. 52, no. 1, 28 June 2004 (2004-06-28), pages 27-32, XP093042705, US ISSN: 0740-3194, DOI: 10.1002/mrm.20140 * the whole document * | 12 | |

TECHNICAL FIELDS
SEARCHED (IPC)

G01R

The present search report has been drawn up for all claims

| Place of search | Date of completion of the search | Examiner |
|---|---|---|
| Munich | 3 May 2023 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20190076080 A